# EUROPEAN PATENT APPLICATION

(11) **EP 2 952 489 A1**
(43) Date of publication of application: **09.12.2015**
(21) Application number: 15167702.8
(22) Date of filing: 13.05.2015
(51) Int. Cl.: C03C 10/00, C03C 17/00, G01C 19/66, G04F 5/14

(54) **SENSOR AND METHODS FOR MAKING SENSORS INCLUDING BARRIER COATING FOR GLASS-CERAMIC**

(30) Priority: 04.06.2014 US 201414295858
(71) Applicant: Honeywell International Inc., Morristown, NJ 07962-2245 (US)
(72) Inventor: Schober, Christina Marie, Morristown, NJ New Jersey 07962-2245 (US); Salit, Kenneth, Morristown, NJ New Jersey 07962-2245 (US); Vescera, James A., Morristown, NJ New Jersey 07962-2245 (US)
(74) Representative: Houghton, Mark Phillip

(57) **Abstract**

Systems and methods for a barrier coating for glass-ceramics are provided. In certain embodiments, a sensor comprises a sensor body, the sensor body enclosing a desired environment within a volume, wherein the sensor body is fabricated from a glass-ceramic; and a barrier coating formed on at least one surface of the sensor body, wherein the barrier coating vacuum seals the desired environment within the volume from an environment external to the volume.

## Description

### BACKGROUND

When ring laser gyroscopes, atomic clocks, and other similar sensors are manufactured, a vacuum sealed environment within the sensor body is desired. For example, when a cold atomic clock is manufactured, rubidium may be introduced into a sealed vacuum. Also, when a ring laser gyroscope is manufactured, helium is sealed within the sensor body. To correctly operate over time, the vacuum seals and the material used to fabricate the sensor body maintain a desired environment within the sensor body. To maintain the vacuum sealed environment, components of the sensor body may be made using glass and optics attached to a borosilicate glass (or other type of glass) using frit. However, fabricating sensor bodies with glass is not without challenges. In particular, machining glass is costly and suffers from producibility issues. For example, glass is sensitive to damage during the machining process, frequently requires chemical etching to remove micro-damage, glass is prone to breakage, and sensitive to failure when placed under tension. Further, special glass machining tools are needed, and post machining assembly, tool contact and handling damage may also occur.

In certain implementations, glass-ceramics may be used in the place of glass when making a sensor body. By using glass-ceramics, many of the costly issues with the machining, handling, and assembly of glass can be avoided. For example, glass-ceramics, such as MACOR, are readily and accurately machined using ordinary metalworking tools within tight tolerances. However, glass-ceramics are more permeable than glass and absorb the contents within the sensor body during the operating and storage life of the product. Also, glass-ceramics may allow permeation of foreign material from the external environment of the sensor into the sensor body. Further, the glass-ceramic may release the contents of the sensor body into the external environment. The absorption of contents, permeation of foreign material, or the release of the contents within or through the sensor body negatively affects the operation of the sensor.

### SUMMARY

Systems and methods for a glass-ceramic barrier coating are provided. In certain embodiments, a sensor comprises a sensor body, the sensor body enclosing a desired environment within a volume, wherein the sensor body is fabricated from a glass-ceramic; and a barrier coating formed on at least one surface of the sensor body, wherein the barrier coating vacuum seals the desired environment within the volume from an environment external to the volume.

### DRAWINGS

Understanding that the drawings depict only exemplary embodiments and are not therefore to be considered limiting in scope, the exemplary embodiments will be described with additional specificity and detail through the use of the accompanying drawings, in which:
Figure 1 is a cross section illustration of a sensor having a barrier coating in one embodiment described in the present disclosure;
Figures 2A and 2B are cross section illustrations of a sensor having interior surfaces coated with a barrier coating in certain embodiments described in the present disclosure;
Figure 2C is a cross section illustration of a sensor having an exterior surface coated with a barrier coating in one embodiment described in the present disclosure; and
Figure 3 is a flow diagram of a method for fabricating a sensor having a barrier coating. in one embodiment described in the present disclosure.

In accordance with common practice, the various described features are not drawn to scale but are drawn to emphasize specific features relevant to the exemplary embodiments.

### DETAILED DESCRIPTION

In the following detailed description, reference is made to the accompanying drawings that form a part hereof, and in which is shown by way of illustration specific illustrative embodiments. However, it is to be understood that other embodiments may be utilized and that logical, mechanical, and electrical changes may be made. Furthermore, the method presented in the drawing figures and the specification is not to be construed as limiting the order in which the individual steps may be performed. The following detailed description is, therefore, not to be taken in a limiting sense.

In certain embodiments, the bodies of sensors, such as atomic clocks and ring laser gyroscopes, among other types of sensors, are fabricated using glass-ceramics. The use of glass-ceramics facilitates the machining of the sensor body, as the glass-ceramic is more resistant to damage during fabrication and is machinable with common tools. Further, as glass-ceramics may be prone to allowing material to pass through the glass-ceramic sensor body and alter the desired environment within the sensor body, the exposed surfaces of the glass-ceramics are coated with a barrier coating. For example, a barrier coating may be applied to the exposed surfaces of the glass-ceramics during the fabrication of the sensor body through dipping, spraying, atomic layer deposition, or the like. The creation of a barrier coating on surfaces of the glass-ceramic prevents the glass-ceramic from absorbing the contents of the sensor body or preventing external gasses outside of the sensor body from entering the sensor body. The preservation of a desired environment inside the sensor body extends the operational life of the sensor.

In certain embodiments, the term "glass-ceramic" refers to polyciystalline materials produced through controlled crystallization of a base glass. As noted by the name, a glass-ceramic material has many of the same properties of both glass and ceramics. Glass-ceramics have fabrication advantages of glass and can be customized to have multiple desired properties. For example, glass-ceramics may be designed to be more machinable and resistant to cracking as compared to glass. Further, other components may be easily joined to the glass-ceramic. Further, electronic circuitry may be printed on the surface of a sensor body fabricated with glass-ceramics.

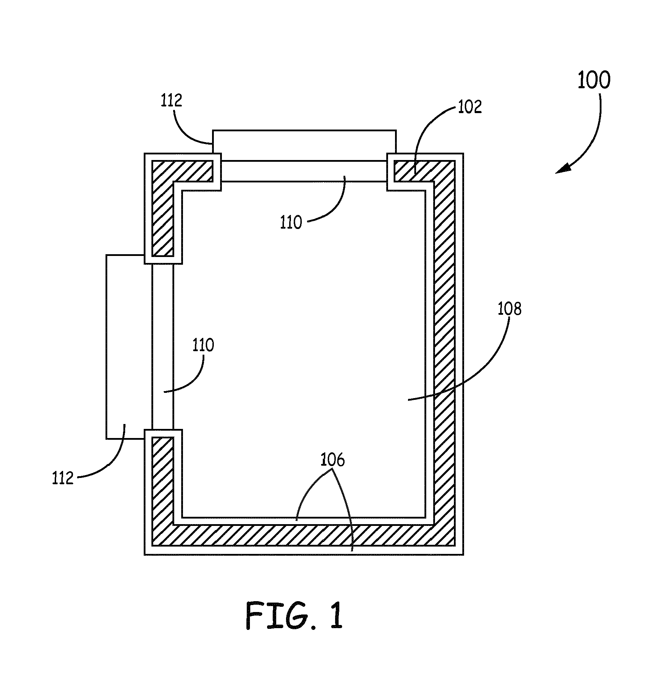

Figure 1 is an illustration of a sensor 100 where the sensor body 102 is fabricated using a glass-ceramic. As used herein, the term "sensor" refers to a sensor that contains a desired environment within a vacuum sealed package. For example, in some implementations, the sensor 100 is an atomic clock. In certain instances, when the sensor 100 is a cold atom clock, the sensor 100 includes a vacuum sealed package that contains vapors of an alkali metal such as rubidium (Rb). When the atomic clock operates, light is used to acquire measurements of the resonance frequency of the atoms inside the atomic clock. These measurements of the resonance frequency can then be used to provide a frequency standard for systems that depend on a consistent clock signal like, for example, a global positioning system satellite.

In other implementations, the sensor 100 is a ring laser gyroscope. A ring laser gyroscope may be used as a navigation instrument to measure rotation rates about an axis of rotation. A ring laser gyroscope typically includes a closed cavity and at least three mirrors designed to reflect light in a loop. The light travels through the closed cavity in both a clock-wise and a counter clock-wise direction. When the ring laser gyroscope is stationary, a beam of light traveling through the cavity in the clock-wise direction has the same frequency as a beam of light traveling through the cavity in the counter clock-wise direction. When the ring laser gyroscope is rotating, the frequency of the clock-wise beam is different than that of the counter clock-wise beam. Utilizing the Sagnac effect, the frequency difference between a first beam traveling in the clock-wise direction and a second beam traveling in the counter clock-wise direction is calculated. This frequency difference can then be used to determine the rotation rate of a body containing the ring laser gyroscope.

With both the atomic clock and the ring laser gyroscope, as described above, and other sensor types, the contents 108 or environment within the sensor body 102 affect the operation of the sensor 100. If the composition of the contents 108 or the desired environment within the sensor body 102 were to change, the performance of the sensor 100 would drift away from the desired performance. When a sensor body 102 is fabricated from glass, the sensor body 102 generally is less permeable by the contents 108 within the interior or by gaseous particles from outside the sensor body 102 than a glass-ceramic such that the environment within the sensor body 102 generally stays the same when the sensor body 102 is made from glass. However, as stated above, glass is difficult to fabricate, especially as the size of the sensors decreases. For example, as the size of the sensors decreases, a glass sensor body is subjected to a greater risk of breaking during the fabrication process or during operation.

In certain implementations, to overcome the short comings of glass, the sensor body 102 may be fabricated from a glass-ceramic. For example, a sensor body 102 may be fabricated from a glass-ceramic like MACOR or another suitable glass-ceramic material. As the sensor body 102 is made from a glass-ceramic, the material used to manufacture the glass-ceramic is machinable using readily available tools. Further, the glass-ceramic sensor body 102 is more resistant to chips and cracking than glass as the sensor body 102 is exposed to external forces during fabrication and operation. However, glass-ceramics may absorb the contents 108 contained within the sensor body 102 or allow the permeation of particles outside the sensor body 102 into the sensor body. Thus, when the environment within the sensor body 102 is exposed to a glass-ceramic, the environment within the sensor body 102 changes over time due to the absorption or permeation of particles through the glass-ceramic. The compositional change may also have an undesirable change on the operation of the sensor100.

In at least one embodiment, to prevent the glass-ceramic in the sensor body 102 from absorbing the contents 108 within the sensor body 102, the surfaces of the sensor body 102 that are in contact with the contents 108 of the sensor body 102 are coated with a barrier coating 106. The barrier coating 106 is a coating of material applied to the surfaces of the sensor body 102 during fabrication to inhibit the absorption/permeation/release of the contents 108 by the sensor body 102. For example, the barrier coating 106 may be a coating of an oxygen barrier formed by nitriding, the application of CERABLAK, a thin film oxide, or the like. When fabricating the sensor 100, the barrier coating 106 may be formed using dipping, spraying, atomic layer deposition (ALD), or other comparable process that would effectively coat the surfaces of the sensor body 102 that would be exposed to the contents 108 save the intermediary barrier coating 106.

In at least one embodiment, when the barrier coating 106 is formed using dipping, the sensor body 102 is dipped into a solution that coats the exposed surfaces of the sensor body 102. After the sensor body 102 is dipped into and removed from the solution, the residual solution that remains on the sensor body 102 is allowed to harden. The process is repeated until the barrier coating 106 that forms on the sensor body 102 reaches a desired thickness. Alternatively, when the barrier coating 106 is formed using spraying, a solution is sprayed onto the exposed surfaces of the sensor body 102. The sprayed solution is then allowed to harden into the barrier coating 106. Further, when the barrier coating 106 is formed through ALD, a barrier coating 106 is allowed to form on surfaces of the sensor body 102 through ALD processes as understood by one having skill in the art. The thickness of the barrier coating 106 may depend on the process used to apply the barrier coating106. For example, applying the barrier coating 106 through dipping and spraying may result in a thicker barrier coating 106 than if the barrier coating 106 had been applied through ALD, which may result in a thickness of the tens of nanometers.

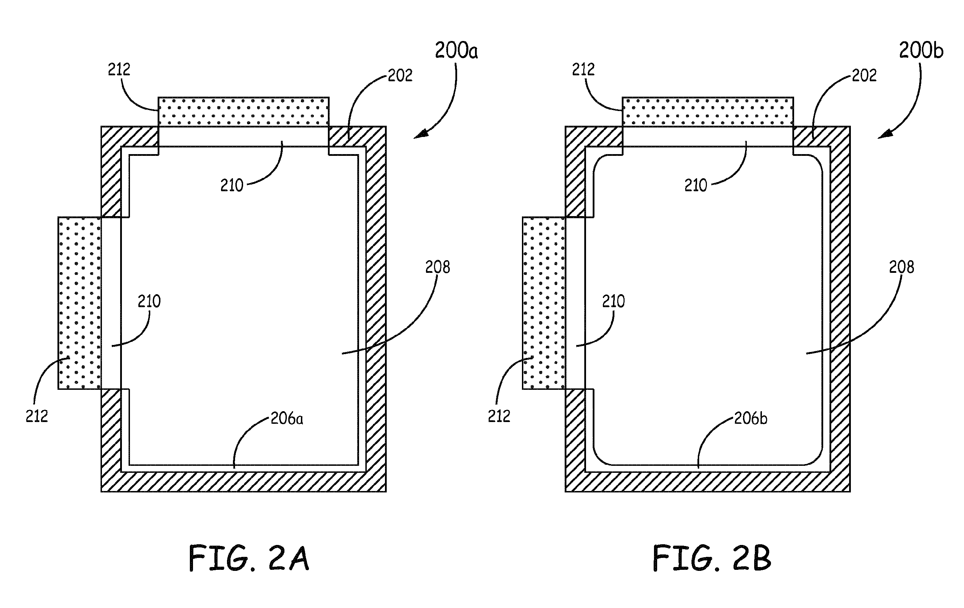

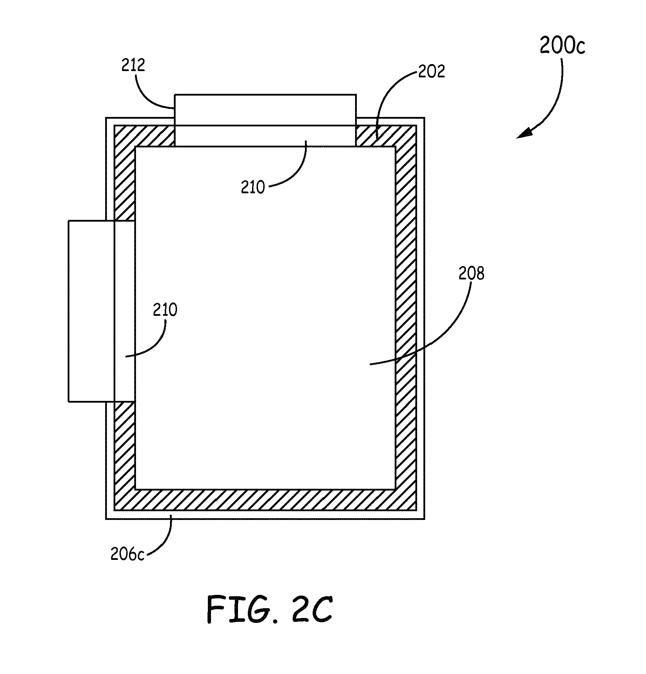

In certain implementations, and as illustrated in Figure 1, both exterior and interior surfaces of the sensor body 102 are coated with the barrier coating 106. Alternatively, as discussed below in relation to Figures 2A and 2B, either the surfaces of the sensor body 102 that could be exposed to the contents 108 are coated or, as illustrated in Figure 2C, the external surfaces of the sensor body 102 are coated with the barrier coating 106. When the desired surfaces of the sensor body 102 are coated with a barrier coating 106, components 112 and other features may be mounted onto the sensor body 102. For example, when the sensor 100 is an atomic clock, components 112 may include optical components like lenses, mirrors, diffraction gratings, or the like, which may be mounted over openings 110 in the sensor body 102. When both exterior and interior surfaces of the sensor body 102 are coated with the barrier coating 106, the components 112 may be bonded to the barrier coating 106 using frit or other type of bonding fabrication method. Alternatively, when only the surfaces of the sensor body 102 exposed to the contents are coated, the components 112 may be bonded to the glass-ceramic material of the sensor body 102.

In certain implementations, the components 112 are mounted on the sensor body 102 before the application of the barrier coating 106. When the components 112 are mounted to the sensor body 102 before the application of the barrier coating 106. The components 112 may be masked to prevent the barrier coating 106 from coating the components 112. However, if the barrier coating 106 is optically transparent, the barrier coating 106 may be applied to the components 112 without masking the components 112.

In at least one implementation, circuitry that supports the operation of the sensor 100 may be formed on the external surface of the sensor body 102 on the glass-ceramic or in the glass-ceramic that comprises the sensor body 102. By including circuitry on or in the glass-ceramic of the sensor body 102, the sensor 100 may be fabricated within a smaller available space. When the circuitry is placed on or in the glass-ceramic of the sensor body 102 and the barrier coating 106 is applied over the external surfaces of the sensor body 102, the circuitry is placed before the application of the barrier coating 106. Alternatively, the circuitry may be printed onto the barrier coating as a post process after the barrier coating is applied. In a further alternative embodiment, when the barrier coating 106 is applied to interior surfaces of the sensor body 102, the circuitry may be placed before or after the application of the barrier coating 106.

As stated above, Figures 2A and 2B provide illustrations of respective sensors 200a and 200b where interior surfaces of the sensor bodies 202 are coated with a respective barrier coating 206a and 206b. As illustrated in Figure 2A, the barrier coating 206a has a conformal thickness on the coated surfaces of the sensor body 202. Methods of application such as dipping and atomic layer deposition may be better able to conformally coat the surfaces of sensor body 202. However, as illustrated in Figure 2B, the barrier coating 206b may have a varying thickness on the coated surfaces of the sensor body 202. Methods of application such as spraying may be more likely to non-conformally coat the surfaces of the sensor body 202 to increase the certainty that the surface of the sensor body 202 is completely covered with the barrier coating 206b. In contrast to Figures 2A and 2B, Figure 2C provides an illustration of a sensor 200c where exterior surfaces of the sensor are coated with a barrier coating 206c. The barrier coating 206c may be applied through spraying, dipping, atomic layer deposition or other methods of applying a coating. Further, the electronic circuitry may be fabricated on the glass-ceramic of the sensor body 202 or on the barrier coating 206c.

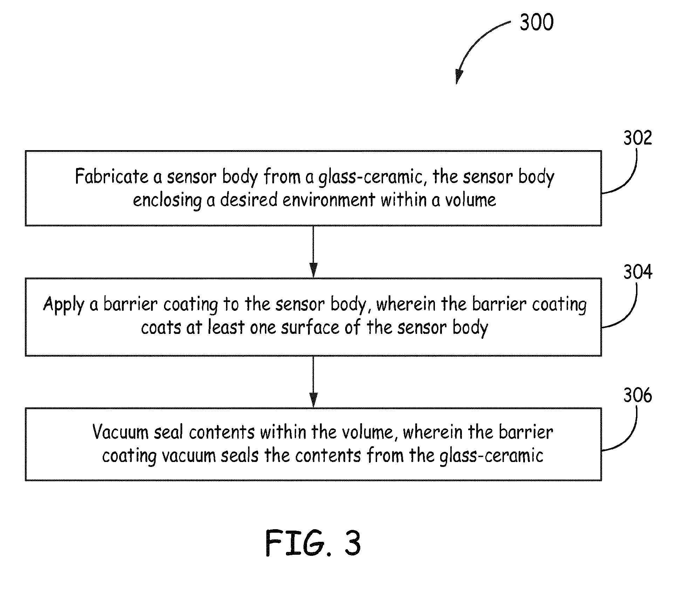

Figure 3 is a flow diagram illustrating a method 300 for fabricating a sensor as described above with respect to Figures 1, 2A, and 2B. In certain embodiments, method 300 proceeds at 302 where a sensor body is fabricated from a glass-ceramic, the sensor body enclosing a volume. For example, in certain implementations, the sensor may be a ring laser gyroscope, an atomic clock, or other similar sensor that isolates a desired environment within an enclosed volume. To improve the ease of fabrication for the sensor body, a glass-ceramic, such as MACOR, may be used. However, glass-ceramics may absorb the contents within the enclosed volume over time. The absorption of the contents may cause performance declines in the operation of the sensor. To inhibit the absorption of the contents by the glass ceramic, method 300 proceeds at 304, where a barrier coating is applied to the sensor body, wherein the barrier coating coats surfaces of the sensor body that are exposed to the volume. For example, a barrier coating may be applied to the surfaces of the sensor body through spraying, dipping, atomic layer deposition, or other method for applying a barrier coating. Method 300 proceeds at 306, wherein a desired environment is vacuum sealed within the volume, wherein the barrier coating isolates the contents from the glass-ceramic. By vacuum sealing the volume and isolating the desired environment from the glass-ceramic, the desired environment may be more effectively maintained within the volume. The maintaining of the desired environment within the volume aid in maintaining the desired operation of the sensors.

### Example Embodiments

Example 1 includes a sensor, the sensor comprising: a sensor body, the sensor body enclosing a desired environment within a volume, wherein the sensor body is fabricated from a glass-ceramic; and a barrier coating formed on at least one surface of the sensor body, wherein the barrier coating vacuum seals the desired environment within the volume from an environment external to the volume.

Example 2 includes the sensor of Example 1, wherein the sensor is one of: an atomic clock; or a ring laser gyroscope.

Example 3 includes the sensor of any of Examples 1-2, wherein the barrier coating has a conformal thickness over the surfaces of the sensor body.

Example 4 includes the sensor of any of Examples 1-3, wherein electronic circuitry is formed on at least one of the sensor body and the barrier coating.

Example 5 includes the sensor of any of Examples 1-4, wherein at least one of external surfaces of the sensor body and internal surfaces of the sensor body are coated with the barrier coating.

Example 6 includes the sensor of any of Examples 1-5, wherein the sensor body comprises one or more openings, the sensor further comprising one or more optical components mounted over the one or more openings such that the one or more optical components vacuum seal the desired environment within the volume.

Example 7 includes the sensor of Example 6, wherein the barrier coating is optically transparent and the barrier coating coats the one or more optical components.

Example 8 includes a method for fabricating a sensor, the method comprising: fabricating a sensor body from a glass-ceramic, the sensor body enclosing a desired environment within a volume; applying a barrier coating to the sensor body, wherein the barrier coating coats at least one surface of the sensor body; and vacuum sealing the desired environment within the volume, wherein the barrier coating vacuum seals the desired environment within the volume from an environment external to the volume.

Example 9 includes the method of Example 8, wherein the barrier coating is applied through one of: dipping the sensor body in a coating solution; spraying a coating solution on the at least one surface of the sensor body; and atomic layer deposition.

Example 10 includes the method of any of Examples 8-9, wherein fabricating the sensor body comprises forming one or more openings in the sensor body.

Example 11 includes the method of Example 10, further comprising mounting one or more optical components to the sensor body over the one or more openings such that the one or more optical components and the sensor body vacuum seals the desired environment within the volume.

Example 12 includes the method of Example 11, wherein applying the barrier coating comprises: applying the barrier coating to the at least one surfaces of the sensor body exposed to the volume; mounting the one or more optical components to the sensor body; masking the one or more optical components; applying the barrier coating to the external surfaces of the sensor body and the one or more optical components; and unmasking the one or more optical components.

Example 13 includes the method of any of Examples 8-12, wherein fabricating the sensor body comprises forming electronic circuitry on at least one of the surface of the glass-ceramic and the surface of the barrier coating.

Example 14 includes the method of any of Examples 8-13, wherein the barrier coating is conformally applied to the at least one surface of the sensor body.

Example 15 includes a sensing apparatus, the apparatus comprising: a sensor body, the sensor body enclosing a desired environment within a volume, wherein the sensor body is fabricated from a glass-ceramic, wherein the sensor body comprises one or more openings; a barrier coating formed on the at least one surface of the sensor body, wherein the barrier coating vacuum seals the desired environment within the volume from an environment external to the volume; and one or more optical components mounted over the one or more openings such that the one or more optical components vacuum seal the desired environment within the volume, wherein the one or more optical components allow at least one light beam to enter the volume.

Example 16 includes the sensing apparatus of any of Examples 1-15, wherein the sensing apparatus is one of: an atomic clock; or a ring laser gyroscope.

Example 17 includes the sensing apparatus of any of Examples 1-16, wherein the barrier coating has a conformal thickness over the surfaces of the sensor body.

Example 18 includes the sensing apparatus of any of Examples 1-17, wherein the electronic circuitry is formed on at least one of the sensor body and the barrier coating.

Example 19 includes the sensing apparatus of any of Examples 1-18, wherein at least one of external surfaces of the sensor and internal surfaces of the sensor body are coated with the barrier coating.

Example 20 includes the sensing apparatus of any of Examples 1-19, wherein the glass-ceramic is MACOR.

Although specific embodiments have been illustrated and described herein, it will be appreciated by those of ordinary skill in the art that any arrangement, which is calculated to achieve the same purpose, may be substituted for the specific embodiments shown.

Therefore, it is manifestly intended that this invention be limited only by the claims and the equivalents thereof.

## Claims

1. A sensor (100), the sensor (100) comprising:
a sensor body (102), the sensor body (102) enclosing a desired environment within a volume, wherein the sensor body (102) is fabricated from a glass-ceramic; and
a barrier coating (106) formed on at least one surface of the sensor body (102), wherein the barrier coating (106) vacuum seals the desired environment within the volume from an environment external to the volume.

2. The sensor (100) of claim 1, wherein the barrier coating (106) has a conformal thickness over the surfaces of the sensor body (102).

3. The sensor (100) of claim 1, wherein electronic circuitry is formed on at least one of the sensor body (102) and the barrier coating (106).

4. The sensor (100) of claim 1, wherein at least one of external surfaces of the sensor body (102) and internal surfaces of the sensor body (102) are coated with the barrier coating (106).

5. The sensor (100) of claim 1, wherein the sensor body (102) comprises one or more openings (110), the sensor further comprising one or more optical components (112) mounted over the one or more openings (110) such that the one or more optical components (112) vacuum seal the desired environment within the volume.

6. A method for fabricating a sensor (100), the method comprising:
fabricating a sensor body (102) from a glass-ceramic, the sensor body (102) enclosing a desired environment within a volume;
applying a barrier coating (106) to the sensor body (102), wherein the barrier coating (106) coats at least one surface of the sensor body (102); and
vacuum sealing the desired environment within the volume, wherein the barrier coating (106) vacuum seals the desired environment within the volume from an environment external to the volume.

7. The method of claim 6, wherein the barrier coating (106) is applied through one of:
dipping the sensor body (102) in a coating solution;
spraying a coating solution on the at least one surface of the sensor body (102); and
atomic layer deposition.

8. The method of claim 6, wherein fabricating the sensor body (102) comprises forming one or more openings (110) in the sensor body (102).

9. The method of claim 8, further comprising mounting one or more optical components (112) to the sensor body (102) over the one or more openings (110) such that the one or more optical components (112) and the sensor body (102) vacuum seals the desired environment within the volume.

10. The method of claim 9, wherein applying the barrier coating (106) comprises:
applying the barrier coating (106) to the at least one surfaces of the sensor body (102) exposed to the volume;
mounting the one or more optical components (112) to the sensor body (102);
masking the one or more optical components (112);
applying the barrier coating (106) to the external surfaces of the sensor body (102) and the one or more optical components (112); and
unmasking the one or more optical components (112).
